# EUROPÄISCHE PATENTSCHRIFT

(11) **EP 2 825 007 B1**
(45) Veröffentlichungstag und Bekanntmachung des Hinweises auf die Patenterteilung: **26.09.2018**
(21) Anmeldenummer: 14002186.6
(22) Anmeldetag: 26.06.2014
(51) Int. Cl.: H05K 5/02, H05K 7/20

(54) **Gehäuse für mindestens ein elektrisches oder elektronisches Gerät und elektrisches oder elektronisches Gerät mit dem Gehäuse**
Housing for at least one electric or electronic device, and electric or electronic device with the said housing
Boîtier pour au moins un appareil électrique ou électronique et appareil électrique ou électronique doté du boîtier

(30) Priorität: 12.07.2013 DE 102013011693; 18.10.2013 DE 102013017402
(43) Veröffentlichungstag der Anmeldung: 14.01.2015
(73) Patentinhaber: Diehl Aerospace GmbH, 88662 Überlingen (DE)
(72) Erfinder: Donner, Bernd, DE - 88682 Salem (DE)
(74) Vertreter: Diehl Patentabteilung

(56) Entgegenhaltungen:
- US-A- 4 609 126
- US-A- 4 750 087
- US-A1- 2007 236 881
- US-A1- 2009 231 807
- US-A1- 2010 073 899

## Beschreibung

Die Erfindung betrifft ein Gehäuse für mindestens ein elektrisches oder elektronisches Gerät. Die Erfindung betrifft weiterhin das elektrische oder elektronische Gerät mit dem Gehäuse. Das Gehäuse umschließt ein Gehäuseinneres, wobei das Gehäuseinnere einen Stauraum aufweist, in dem das elektrische oder elektronische Gerät anordbar ist. Das Gehäuse umfasst ein Gehäuseoberteil, das das Gehäuseinnere begrenzt und mindestens einen Zwischendeckenabschnitt, der im Gehäuseinneren unterhalb des Gehäuseoberteils angeordnet ist. Der Zwischendeckenabschnitt schließt zusammen mit dem Gehäuseoberteil einen Zwischenraum ein. Der Zwischendeckenabschnitt weist mindestens einen Kühlluftdurchlass auf, durch den Kühlluft vom Stauraum in den Zwischenraum strömen kann, wobei das Gehäuseoberteil mindestens eine Kühlluftöffnung aufweist, durch die die Kühlluft aus dem Zwischenraum nach außen entweichen kann.

Gehäuse für elektrische oder elektronische Geräte, insbesondere Rechnergehäuse, weisen üblicherweise Öffnungen auf, über die das Gehäuses belüftet werden kann, um beim Betrieb des elektrischen oder elektronischen Geräts eine Überhitzung zu vermeiden. Es sind bereits Gehäuse bekannt geworden, die ein Wasserführungssystem zur Führung und Ableitung von Kondens- und/oder Tropfwasser aufweisen.

Beispielsweise beschreibt die Druckschrift EP 1 370 125 B1, die wohl den nächstliegenden Stand der Technik bildet, eine Luftdurchtrittseinrichtung mit einem Lüftungsgitter, das aus einem Rahmen mit einer mit Lamellen und/oder Luftschlitzen versehenen Frontplatte und einer halsartigen Einziehung ausgebildet ist. Die Luftdurchtrittseinrichtung umfasst einen Trägerkörper, der aus einem Rahmen mit einer umlaufenden Wandfläche und mit einem Innenraum zur Aufnahme der halsartigen Einziehung ausgebildet ist. Der Trägerkörper weist an einer dem Lüftungsgitter abgewandten Seite Luftdurchtrittsöffnungen und Wasserableitstege zum Ableiten von eingedrungenem Spritzwasser und Kondenswasser auf.

Aus der US 4,750,087 A ist eine Tragschienenstruktur bekannt, die Kühlluft zur Entfernung von Wärme aus Instrumenten zur Verfügung stellt. Die Tragschienenstrukturen sorgen für eine gleichmäßige Kühlung entlang jeder Tragschiene unabhängig von der Instrumentenorientierung innerhalb der Instrumententafelanordnung. Ein System, das die Kombination einer Instrumententafel-Tragschiene und Kühl-Verteiler einschließt, entlädt einen kontinuierlichen Fluss von erzwungener Konvektionsluft entlang der Basis der Tragschiene. Es werden Ventile gezeigt, die eine Durchflusskühlung für Kathodenstrahlröhreninstrumente ermöglichen. Die Instrumententafel-Tragschienenstrukturen ermöglichen eine Methode zur Bereitstellung von gekühlter Luft, wenn die Konzentration der Instrumententafeln vorschreibt, dass die Klimaanlage in die Tafeln integriert ist.

Aus der US 4,609,126 A ist eine belüftete Kappe zum Abdecken eines Gerätegehäuses bekannt, das in einer Außenumgebung verwendet wird, die ein Paar von beabstandeten Dachplatten enthält, die dazwischen eine Kammer definieren. Öffnungen in den Dachplatten, die nicht deckungsgleich sind, bieten einen Weg für die Belüftung der Umgrenzung und verhindern das Eindringen von Umwelteinflüssen wie Regen. Erhöhte Ebenen werden über die Oberfläche der inneren Dachplatte erhoben und enthalten jeweils eine der inneren Öffnungen. Ablaßöffnungen sind rund um den Umfang der belüfteten Kappe gebildet und unterstützen die Möglichkeit zum Austreten von Umweltelementen von und das Eindringen von Kühlluft in die Kammer.

Aus der US 2009/0231807 A1 ist ein wasserdichtes, belüftetes Gehäuse zur Aufnahme von Ausrüstung bekannt, das die Fähigkeit hat, Wasser durch das Gehäuse zu kanalisieren, ohne das Gerät zu berühren, und ferner mit der Fähigkeit, eine aktive oder passive Belüftung an dem Gerät zu bieten. Im bevorzugten Fall handelt es sich bei dem Gerät um einen Videomonitor, der in einer Außenumgebung montiert werden kann. Das Gehäuse enthält Strukturen, die Flüssigkeit von Luft durch die gleichen oder verwandte Öffnungen trennen, aber Vermischen verhindern.

Der Erfindung liegt die Aufgabe zugrunde, ein funktional verbessertes Gehäuse für eine elektrische oder elektronische Baueinheit Gerät bereitzustellen. Diese Aufgabe wird durch ein Gehäuse mit den Merkmalen des Anspruchs 1 und durch ein elektrisches oder elektronisches Gerät mit den Merkmalen des Anspruchs 12 gelöst. Bevorzugte oder vorteilhafte Ausführungsformen der Erfindung ergeben sich aus den Unteransprüchen der nachfolgenden Beschreibung und/oder den beigefügten Figuren.
Es wird ein Gehäuse für mindestens eine elektrische oder elektronische Baueinheit vorgeschlagen. Vorzugsweise ist die elektrische oder elektronische Baueinheit als eine Leiterkarte, insbesondere Leiterplatte, als ein Leiterkabel und/oder als eine Steckverbindung ausgebildet.
Das Gehäuse umschließt ein Gehäuseinneres, das einen Stauraum aufweist. Vorzugsweise entspricht das Gehäuseinnere einem Volumen des Gehäuses. Die elektrische oder elektronische Baueinheit ist in dem Stauraum anordbar.
Das Gehäuse umfasst ein Gehäuseoberteil, das das Gehäuseinnere insbesondere nach oben, begrenzt. Das Gehäuse kann einteilig oder mehrteilig ausgebildet sein. Vorzugsweise weist das Gehäuse ein Gehäuseunterteil mit einer Gehäuseunterseite und mit mehreren Seitenwänden auf, wobei die Seitenwände zum Beispiel als eine Stirn- und/oder Rückwand und/oder als seitliche Längsseiten ausgebildet sein können.
Bevorzugt ist das Gehäuseoberteil auf das Gehäuseunterteil, insbesondere auf die Seitenwände aufgesetzt und/oder aufsetzbar. Optional ist das Gehäuseoberteil von diesem/diesen in der mehrteiligen Ausgestaltung des Gehäuses beschädigungs- und/oder zerstörungsfrei abnehmbar. In diesem Fall ist vorzugsweise zwischen dem Gehäuseunterteil, insbesondere zwischen mindestens einer der Seitenwände und dem Gehäuseoberteil, eine Dichtungseinrichtung, zum Beispiel eine Flachdichtung, angeordnet. Dadurch kann verhindert werden, dass Feuchtigkeit durch Kapillarwirkung zwischen dem Gehäuseunterteil und dem Gehäuseoberteil ins Gehäuseinnere eindringen kann.
Bevorzugt ist das Gehäuse durchgängig für Kühlluft ausgebildet. Dies bedeutet insbesondere, dass das Gehäuse Be- und/oder Entlüftungsströme beziehungsweise Be- oder Entlüftungszirkulationen von Kühlluft gewährleistet. Insbesondere ist das Gehäuse dazu ausgebildet, zwangsgekühlt zu werden. Hierfür weist das Gehäuseunterteil, insbesondere die Gehäuseunterseite und/oder mindestens eine der Seitenwände, mindestens einen Kühllufteinlass auf. Durch den Kühllufteinlass kann die Kühlluft von außen, insbesondere aus einer Umgebung des Gehäuses, in das Gehäuseinnere, insbesondere in den Stauraum, zur Kühlung des dort anordbaren elektrischen oder elektronischen Geräts, zugeführt werden bzw. einströmen. Beispielsweise wird die Kühlluft aktiv, z.B. durch Einsatz eines Ventilators oder Gebläses, durch den Kühllufteinlass in das Gehäuseinnere eingeblasen. Es ist alternativ im Rahmen der Erfindung möglich, dass die Kühlluft durch natürliche Luftzirkulation und/oder passive Konvektion in das Gehäuseinnere einströmt.

Das Gehäuse umfasst mindestens einen Zwischendeckenabschnitt, der im Gehäuseinneren unterhalb des Gehäuseoberteils angeordnet ist. Optional umfasst das Gehäuseoberteil den Zwischendeckenabschnitt. Hierbei kann der Zwischendeckenabschnitt mit dem Gehäuseoberteil fest verbunden sein oder lediglich mit diesem lösbar gekoppelt sein. Beispielsweise ist der Zwischendeckenabschnitt als ein vom Gehäuseoberteil abgehängter Deckenabschnitt ausgebildet. Der Zwischendeckenabschnitt kann aber auch als ein separates Bauteil ausgebildet sein.

Der Zwischendeckenabschnitt schließt zusammen mit dem Gehäuseoberteil einen Zwischenraum ein. Insbesondere umfasst das Gehäuseinnere den Zwischenraum. Der Zwischendeckenabschnitt weist mindestens einen Kühlluftdurchlass auf, durch den die Kühlluft vom Stauraum in den Zwischenraum strömen kann.

Das Gehäuseoberteil weist mindestens einen Kühlluftauslass auf, durch den die Kühlluft aus dem Zwischenraum nach außen entweichen kann. Vorzugsweise ist der Kühlluftauslass als mindestens eine Öffnung und/oder Bohrung im Gehäuseoberteil ausgebildet.

Der Zwischendeckenabschnitt bildet eine Auffangeinrichtung für Tropfwasser, insbesondere Kondenswasser, das durch den Kühlluftauslass in den Zwischenraum eindringt. Bevorzugt ist der Zwischendeckenabschnitt unterhalb der Gehäuseabdeckung und zugleich deckungsgleich oder überlappend mit dem Kühlluftauslass angeordnet. Somit kann das Tropfwasser durch den Kühlluftauslass in den Zwischendeckenabschnitt eintropfen. Beispielsweise ist der Zwischendeckenabschnitt in der Ausbildung als die Auffangeinrichtung als ein Sammelkanal, als eine Rinne und/oder Wanne für das Tropfwasser ausgebildet. Optional ergänzend ist der Zwischendeckenabschnitt als eine Ablaufeinrichtung ausgebildet. In diesem Fall kann das Tropfwasser im Zwischendeckenabschnitt nicht nur aufgefangen werden, sondern auch in dem Zwischendeckenabschnitt z.B. zu einer Abflussöffnung hin geleitet werden bzw. zu der Abflussöffnung ablaufen.

Es ist von Vorteil, dass die Kühlluft durch den Kühlluftauslass aus dem Gehäuseinneren entweichen kann und zugleich das durch den Kühlluftauslass eindringende Tropfwasser in der Auffangeinrichtung gesammelt werden kann. Dadurch kann verhindert werden, dass das Tropfwasser in den Stauraum eindringt und die dort anordbare und/oder angeordnete elektrische oder elektronische Baueinheit beschädigt.

Mit dem im Rahmen der Erfindung vorgeschlagenen Zwischendeckenabschnitt kann ein einfacher Geräteaufbau erreicht werden. Insbesondere benötigt der Zwischendeckenabschnitt als die Auffangeinrichtung nur einen geringen Bauraum im Gehäuseinneren. Somit wird gewährleistet, dass das Gehäuseinnere bestmöglich ausgenutzt wird. Insbesondere werden Aufnahmen und/oder Bestückungsflächen die elektrische oder elektronische Baueinheit im Wesentlichen nicht eingeschränkt.

Zusammenfassend ermöglicht das im Rahmen der Erfindung vorgeschlagene Gehäuse in vorteilhafter Weise eine Zwangskühlung (forced air cooling) bei gleichzeitiger Tropfwasserdichtigkeit (drip waterproofness).

In einer besonders bevorzugten konstruktiven Umsetzung ist der Zwischendeckenabschnitt in einem lotrechten und/oder senkrechten Querschnitt, insbesondere in einem Querschnitt, dessen Schnittlinie parallel zu einer der Seitenwände verläuft, U-förmig ausgebildet. Vorzugsweise ist ein erster Schenkel des U's als ein erster Zwischendeckensteg, ein zweiter Schenkel des U's als ein zweiter Zwischendeckensteg und eine Querverbindung des U's als ein Zwischendeckenboden ausgebildet. Insbesondere stehen der erste und zweite Zwischendeckensteg vom Zwischendeckenboden winklig in Richtung des Gehäuseoberteils ab.

Optional ist der Zwischendeckenboden parallel zum Gehäuseoberteil angeordnet. Bevorzugt ist durch die U-förmige Ausgestaltung des Zwischendeckenabschnitts ist die Auffangeinrichtung und optional ergänzend die Ablaufeinrichtung gebildet. Insbesondere kann das Tropfwasser durch die U-förmige Ausbildung des Zwischendeckenabschnitts gesammelt und optional auch abgeleitet werden. Vorzugsweise bildet der Zwischendeckenboden einen Grund des Sammelkanals.

Optional weist der Zwischendeckenabschnitt, insbesondere der Zwischendeckenboden, ein Gefälle auf. Hierbei verläuft der Zwischendeckenabschnitt, insbesondere der Zwischendeckenboden, in seiner Längsersterstreckung vorzugsweise schräg und/oder winklig gegenüber dem Gehäuseoberteil und/oder gegenüber einer der Seitenwände in Richtung der Abflussöffnung. Dadurch wird das Abfließen des Tropfwassers in vorteilhafter Weise unterstützt und beschleunigt.

Alternativ oder optional ergänzend kann der Zwischendeckenboden und/oder die zum Zwischendeckenboden gerichteten Innenseiten der Zwischendeckenstege eine Adhäsion verringernde Beschichtung, z.B. einen Nanolack, aufweisen. Dadurch kann im Zwischendeckenabschnitt ein sogenannter Lotuseffekt erreicht werden, durch den das Tropfwasser leichter und schneller zur Abflussöffnung abfließen kann.

Es ist bevorzugt, dass ein Abstand zwischen dem ersten und zweiten Zwischendeckensteg und/oder eine Breite des Zwischendeckenbodens so dimensioniert ist, dass Tropfen des Tropfwassers durch Adhäsion auf dem Zwischendeckenboden gehalten werden.

Besonders bevorzugt ist, dass der Kühlluftdurchlass im ersten Zwischendeckensteg und/oder im zweiten Zwischendeckensteg angeordnet ist. Alternativ ist der Kühlluftdurchlass durch den ersten und/oder zweiten Zwischendeckensteg gebildet. Insbesondere ist der Kühlluftdurchlass vom Zwischendeckenboden beabstandet und nach oben versetzt angeordnet. Im Speziellen ist eine Unterkante des Kühlluftauslasses vom Zwischendeckenboden beabstandet, sodass der Kühlluftdurchlass nicht bis zum Zwischendeckenboden reicht. Beispielsweise ist der Kühlluftdurchlass in einem oberen Drittel des ersten und/oder zweiten Zwischendeckenstegs oder sogar unmittelbar unterhalb der Gehäuseabdeckung im ersten und/oder zweiten Zwischendeckensteg angeordnet. Die unter dem Kühlluftdurchlass liegenden Abschnitte des ersten und/oder zweiten Zwischendeckenstegs sind insbesondere als Wasserbarrieren oder als Wehre gegen das Tropfwasser ausgebildet. Dadurch kann in vorteilhafter Weise erreicht werden, dass das auf dem Zwischendeckenboden aufgefangene Tropfwasser an einem Ein- und/oder Durchfließen in den Kühlluftdurchlass und an einem Eindringen in den Stauraum des Gehäuses gehindert wird.

Der Kühlluftdurchlass ist in dem lotrechten und/oder senkrechten Querschnitt, insbesondere in dem Querschnitt, dessen Schnittlinie parallel zu einer der Seitenwände des Gehäuses verläuft, seitlich versetzt zum Kühlluftauslass angeordnet. Insbesondere ist der Kühlluftdurchlass in dem Querschnitt deckungsungleich zum Kühlluftauslass angeordnet. Dadurch, dass der Kühlluftdurchlass in dem Querschnitt seitlich versetzt zum Kühlluftauslass angeordnet ist, wird ein direkter Fließweg für das Tropfwasser vom Zwischenraum in das Geräteinnere vermieden. Dadurch kann in vorteilhafter Weise ein Eindringen des Tropfwassers ins Gehäuseinnere vermieden werden. Zusammenfassend wird festgestellt, dass das Gehäuse hinsichtlich einer Durchlüftung offen und hinsichtlich des Tropfwassers undurchlässig ausgebildet ist.

Durch die im Querschnitt seitlich versetzte Anordnung des Kühlluftauslasses und Kühlluftdurchlasses wird es in vorteilhafter Weise ermöglicht, dass das Tropfwasser trotz der Durchlässigkeit für die Kühlluft des Gehäuses nicht in das Gehäuseinnere eindringen kann. Somit kann eine Zwangsentlüftung und/oder Zwangsbelüftung des Gehäuseinneren erreicht werden, was insbesondere mit vergleichsweise geringen finanziellen und/oder technischem Aufwand umsetzbar ist. Vorteilhaft ist ebenfalls, dass eine Tropfwasserabschottung ohne aufwendige luftdichte Kanäle erreicht werden kann. Ferner kann mit dem erfindungsgemäßen Zwischendeckenabschnitt auch ohne speziell dafür vorgesehene Dichtungen und/oder Luftfilterelemente eine zuverlässige Tropfwasserabschottung ermöglicht werden.

In einer bevorzugten Ausgestaltung der Erfindung ist eine erste Ebene, die durch den Kühlluftauslass verläuft, winklig zu einer zweiten Ebene angeordnet, die durch den Kühlluftdurchlass verläuft. Optional ergänzend sind der Kühlluftdurchlass und der Kühlluftdurchlass auf zwei Ebenen und/oder in der Höhe zueinander versetzt angeordnet.

Besonders bevorzugt wird die Kühlluft beim Strömen vom Stauraum durch den Kühlluftdurchlass in den Zwischenraum und vom Zwischenraum durch den Kühlluftauslass nach außen mindestens zwei Mal in ihrer Strömungsrichtung umgelenkt. Vorzugsweise ändert sich die Strömungsrichtung mindestens zwei Mal um mindestens 60 Grad, vorzugsweise um mindestens 90 Grad, insbesondere um mindestens 140 Grad und/oder maximal um 180 Grad. Durch die Umlenkung der Kühlluft auf ihrem Strömungsweg vom Stauraum über den Zwischenraum nach außen besteht kein direkter Fließweg für das Tropfwasser vom Zwischenraum in den Stauraum.

In einer bevorzugten Umsetzung der Erfindung weist das Gehäuseoberteil eine erste und zweite Rippe auf. Vorzugsweise schließen sich die erste und zweite Rippe seitlich an den Kühlluftauslass an und stehen von dem Gehäuseoberteil winklig, insbesondere rechtwinklig, in den Zwischenraum ab. Dadurch mündet der Kühlluftauslass in der bevorzugten Umsetzung zwischen der ersten und zweiten Rippe. Beide Rippen verlaufen bevorzugt durchgehend und/oder parallel auf einer zum Gehäuseinneren gerichteten Innenseite des Gehäuseoberteils.

Eine mögliche Ausgestaltung der Erfindung sieht vor, dass die erste und zweite Rippe als Abtropfrippen für das durch den Kühlluftauslass in den Zwischenraum eindringende Tropfwasser ausgebildet sind. Somit wird das Tropfwasser entlang der ersten und zweiten Rippe geleitet und zum direkten Abtropfen auf den Zwischendeckenboden veranlasst. Dadurch kann in vorteilhafter Weise verhindert werden, dass das Tropfwasser entlang der Innenseite des Gehäuseoberteils zu den Seitenwänden fließt und über diese in den Stauraum gelangt.

Bevorzugt weist mindestens eine der Seitenwände des Gehäuses mindestens eine Abflussöffnung auf. Vorzugsweise mündet der Zwischendeckenboden als die Auffangeinrichtung und als die Ablaufeinrichtung in der mindestens einen Abflussöffnung, sodass das dort aufgefangene und gesammelte Tropfwasser nach außen geleitet werden kann. Beispielsweise ist die mindestens eine Abflussöffnung in der Stirn- oder Rückwand des Gehäuses angeordnet.

Eine bevorzugte Ausführungsform der Erfindung sieht vor, dass das Gehäuse mindestens eine Ableiteinrichtung zur gezielten Ableitung des aus der Abflussöffnung ausgeleiteten Tropfwasser, z.B. um Stecker herum, aufweist. Vorzugsweise ist die Ableiteinrichtung auf einer dem Gehäuseinneren gegenüberliegenden Außenseite mindestens einer der Seitenwände angeordnet. Alternativ oder optional ergänzend ist die oder eine weitere Ableiteinrichtung auf einer Innenseiten der Seitenwände angeordnet. Beispielsweise ist die Ableiteinrichtung als ein Ableitschirm oder als eine Ableitrinne ausgebildet.

Gemäß der Erfindung weist das Gehäuse mehrere, insbesondere mindestens drei, vorzugsweise mindestens fünf und/oder maximal 15, Zwischendeckenabschnitte auf. Die Zwischendeckenabschnitte sind durch Stegverbindungen miteinander verbunden. Jeweils eine der Stegverbindungen ist zwischen zwei benachbarten Zwischendeckenstegen zweier benachbarter Zwischendeckenabschnitte angeordnet. Die zwei benachbarten Zwischendeckenstege bilden zusammen mit der Stegverbindung eine Aufnahme, in der die elektrische oder elektronische Baueinheit, insbesondere in der Ausbildung als die Leiterkarte, anordbar ist. Somit ist zwischen jeweils zwei benachbarten Zwischendeckenabschnitten eine Leiterkarte insbesondere senkrecht zum Gehäuseoberteil anordbar. Insbesondere wird die Leiterkarte zwischen den Zwischendeckenstegen der beiden benachbarten Zwischendeckenabschnitte eingesteckt und/oder eingeklemmt. Hierbei bilden die Zwischendeckenstege der zwei benachbarten Zwischendeckenabschnitte eine Bestückungsfläche für die Leiterkarte und/oder eine Leiterkartenführung. Insbesondere kann die Leiterkarte form- und/oder reibschlüssig zwischen den Zwischendeckenstegen der zwei benachbarten Zwischendeckenabschnitte gehalten werden.

Eine mögliche Ausführungsform der Erfindung sieht vor, dass die mehreren miteinander verbundenen Zwischendeckenabschnitte eine Zwischenebene bilden. Optional erstreckt sich die Zwischenebene unterhalb des Gehäuseoberteils und/oder parallel zu diesem. Vorzugsweise ist die Zwischenebene labyrinthartig ausgebildet und/oder bildet ein Labyrinthsystem. Bevorzugt ist das Labyrinthsystem im Wesentlichen im Gehäuseinneren angeordnet. Insbesondere wird die labyrinthartige Ausbildung und/oder das Labyrinthsystem durch die vorzugsweise in den Zwischendeckenstegen beabstandet vom jeweiligen Zwischendeckenboden angeordneten Kühlluftdurchlässe gebildet. Alternativ oder optional ergänzend wird die labyrinthartige Ausbildung und/oder das Labyrinthsystem durch den zum Kühlluftauslass vorzugsweise seitlich versetzt angeordneten Kühlluftdurchlass gebildet. Insbesondere gelangt die Kühlluft nicht auf einem direkten "geraden" Weg vom Kühllufteinlass zum Kühlluftauslass. Vielmehr wird die Kühlluft, wie bereits zuvor beschrieben, bevorzugt mehrmals auf ihrem Strömungsweg durch das Gehäuseinnere, insbesondere durch die Zwischenebene und den Zwischenraum hindurch, wie bei einem Labyrinth mehrmals umgelenkt. Bevorzugt ist ebenfalls, dass das Tropfwasser durch die spezielle Ausgestaltung des Gehäuses vom Labyrinthsystem nach außen abgeführt werden kann.

Vorteilhaft ist, dass das Labyrinthsystem keinen direkten Fließweg des Tropfwassers in das Gehäuseinnere und/oder in das Geräteinnere bietet. Somit wird ein Eindringen von externem Tropfwasser in das Gehäuse- und/oder Geräteinnere unterbunden. Zudem ist das Labyrinthsystem optional dazu ausgebildet und eingerichtet, das Tropfwasser nach außen abzuführen. Vorteilhaft ist weiterhin, dass durch das Labyrinthsystem bzw. die Labyrinthstruktur ein relativ einfacher Gehäuse- und/oder Geräteaufbau erreicht werden kann.

Ein weiterer Gegenstand der Erfindung betrifft ein elektrisches oder elektronisches Gerät, insbesondere ein luftfahrttechnisches Gerät, mit dem Gehäuse nach einem der Ansprüche 1 bis 11 und/oder nach der bisherigen Beschreibung. Das elektrische oder elektronische Gerät umfasst die mindestens eine elektrische oder elektronische Baueinheit. Diese ist im Stauraum angeordnet und insbesondere in der Ausbildung als Leiterkarte zwischen die zwei benachbarten und miteinander verbundenen Zwischendeckenabschnitten eingesetzt. Die Kühlluft, die vorzugsweise durch Kühllufteinlässe im Gehäuseunterteil, insbesondere in der Gehäuseunterseite, in den Stauraum einströmt, wird senkrecht zu einer Flächenerstreckung des Gehäuseoberteils entlang der vorzugsweise senkrecht stehenden Leiterkarte nach oben zum Kühlluftdurchlass geleitet. Somit kann die Leiterkarte besonders effektiv durch die Kühlluft gekühlt werden.

Besonders bevorzugt ist, dass das elektrische oder elektronische Gerät als ein Rechner, insbesondere als ein Avionik-Rechner für die Luftfahrtindustrie, insbesondere zur Integration in ein Flugzeug, ausgebildet ist. Beispielsweise ist das elektrische oder elektronische Gerät nach dem ARINC 600- Standard ausgebildet. Geräte nach dem ARINC 600- Standard weisen üblicherweise, je nach Verlustleistung, eine große Anzahl an Kühlluftauslässen auf. Hierbei können z.B. 160 Kühlluftauslässe mit einem Durchmesser von jeweils 3,2 Millimetern in das Gehäuseoberteil eingebracht sein. Alternativ können in das Gehäuseoberteil mehr als 160 Kühlluftauslässe eingebracht sein, wobei diese auch andere Durchmessern und/oder Größen aufweisen können. Vorzugsweise ist das Gehäuse bzw. das elektrische oder elektronische Gerät nach dem ARINC 600-Standard ausgebildet.

Die Kühlluftauslässe sind in Anzahl und Durchmesser und/oder Größe bevorzugt so ausgebildet, dass sie einen Gesamtauslassquerschnitt aufweisen, bei dem bei einem Ausfall der aktiven Kühlung des Gerätes, insbesondere bei einem Ausfall einer flugzeugseitigen Kühlluftversorgung, eine Verlustwärme über natürliche Konvektion aus dem Gehäuseinneren entweichen kann. Somit kann in vorteilhafter Weise gewährleistet werden, dass das elektrische oder elektronische Gerät für eine gewisse Zeit bei einer bestimmten Umgebungstemperatur funktionsfähig bleibt.

Ein Tropfwassertest mit dem erfindungsgemäßen Gerät ist in der DO-160 Section 10, Cat. W (DO-160: Environmental Conditions and Test Procedures for Airborne Equipment) spezifiziert. Demnach werden bei Aufbringung von 140 Litern Wasser pro Quadratmeter pro Stunde (l/qm²/Std) und bei einer Fallhöhe von einem Meter auf die Gehäuseoberseite für das hier beschriebene Gerät in 15 Minuten 2,15 Liter Tropfwasser erzeugt.

Das im Rahmen der Erfindung vorgeschlagene Gehäuse ermöglicht durch die Tropfwasserabschottung, dass eine Lackierung der mindestens einen elektrischen oder elektronischen Baueinheit, insbesondere der mindestens einen Leiterplatte, der Leiterkabel und/oder Steckverbindungen, nicht zwingend erforderlich ist. Somit können Zeit und Kosten bei der Herstellung des elektrischen oder elektronischen Geräts eingespart werden. Zum Hintergrund sei erwähnt, dass Leiterkabel und/oder Leiterkarten im Gehäuse zumindest teilweise schutzlackiert sein können und somit vor dem Tropfwasser geschützt sind. Es gibt jedoch auch Bereiche, insbesondere im Bereich von Steckverbindungen, die nur mit äußerst hohem wirtschaftlichen und/oder technischen Aufwand wasserdicht ausgeführt, z.B. lackiert, werden können. Insbesondere hätte eine vollständige Schutzlackierung im Bereich der Steckverbindungen möglicherweise negative Auswirkungen für die Wartbarkeit des elektrischen oder elektronischen Geräts.

Zusammenfassend ermöglicht die vorliegende Erfindung die Verwirklichung eines "offenen" kühlluftdurchströmten Gerätes mit einfachem Gehäuseaufbau.

Weitere Merkmale, Wirkungen und Vorteile der Erfindung ergeben sich aus der nachfolgenden Beschreibung bevorzugter Ausführungsbeispiele der Erfindung sowie der beigefügten Figuren. Dabei zeigen:
- Figur 1: eine perspektivische Sicht auf ein elektrisches Gerät mit einem Gehäuse, das ein Gehäuseoberteil und ein Gehäuseunterteil aufweist;
- Figur 2: das elektrische Gerät aus Fig. 1, wobei das Gehäuseoberteil vom Gehäuseunterteil abgenommen ist;
- Figur 3: eine Schnittansicht durch das Gehäuseoberteil, wobei eine Schnittlinie parallel zu einer Stirnseite des Gehäuses verläuft;
- Figur 4: ein Detailausschnitt aus der Schnittansicht der Fig. 3, in der ein Strömungsweg einer Kühlluft gezeigt ist;
- Figur 5: das elektrische Gerät aus Fig. 1 mit einem alternativen Gehäuse;
- Figur 6: das elektrische Gerät mit dem alternativen Gehäuse aus Fig. 5, wobei das Gehäuseoberteil vom Gehäuseunterteil abgenommen ist;
- Figur 7: der Detailausschnitt aus Fig. 3, in dem der Strömungsweg der Kühlluft und ein Fließweg eines Tropfwassers gezeigt ist;
- Figur 8: eine Detaildarstellung des alternativen Gehäuses aus Fig. 5, wobei eine erste seitliche Längsseite des Gehäuses und ein Teil des Gehäuseoberteils transparent dargestellt ist.

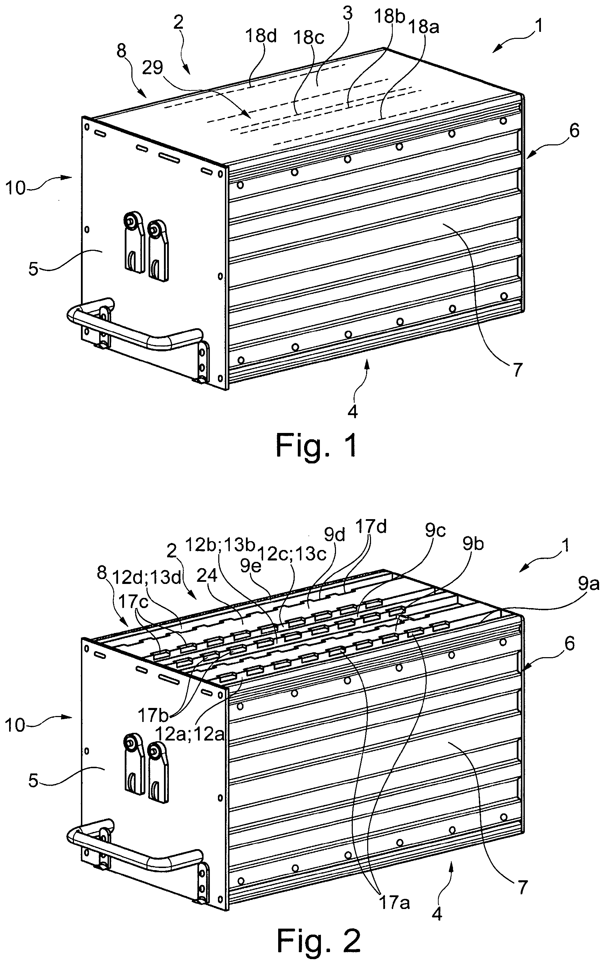

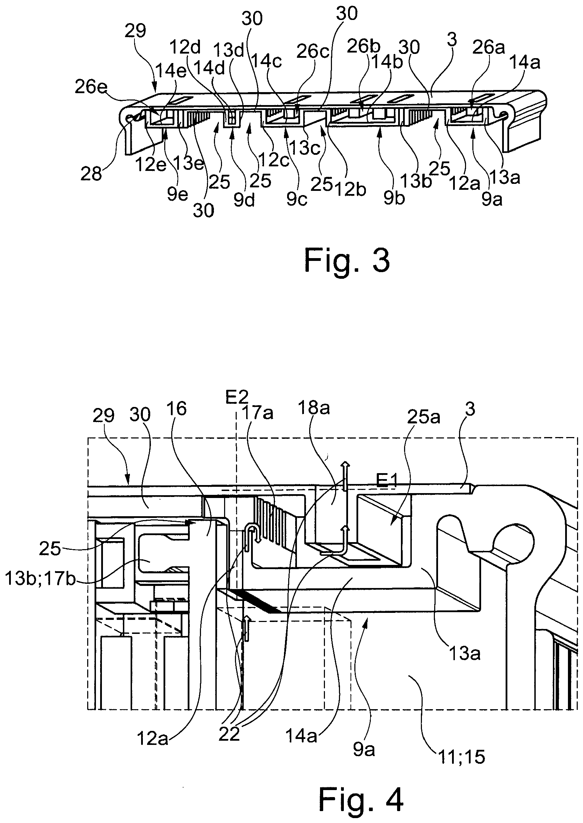

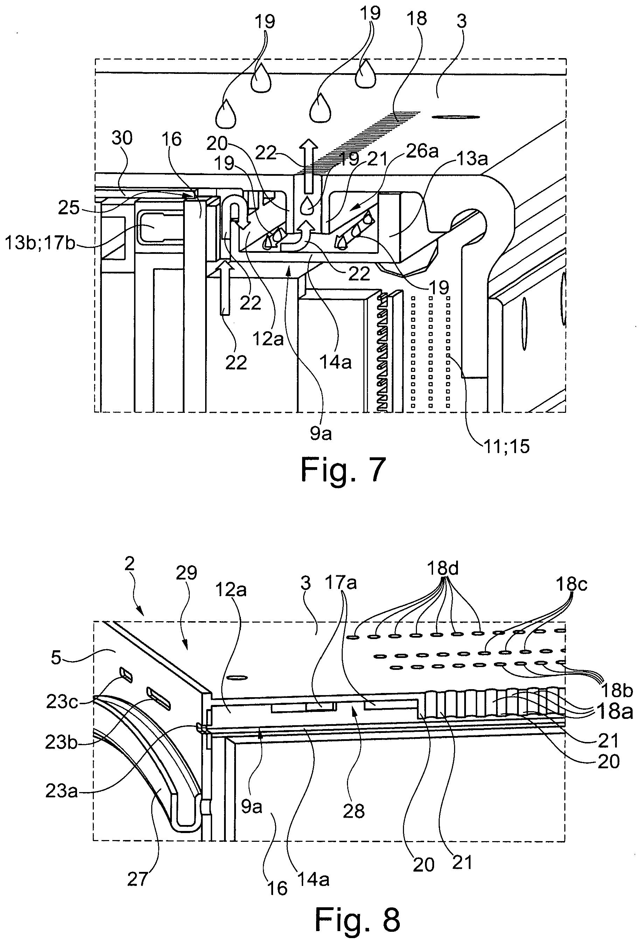

Figur 1 zeigt eine perspektivische Sicht auf ein elektrisches oder elektronisches Gerät 1 mit einem Gehäuse 2. Das elektrische oder elektronische Gerät 1 ist als ein Avionik-Rechner für den Luftfahrtbereich ausgebildet. Es umfasst mindestens eine elektrische oder elektronische Baueinheit 16, insbesondere eine Leiterkarte (siehe Fig. 3; 7).

Das Gehäuse 2 schließt ein Gehäuseinneres 11 (Fig. 4; 7) ein. Das Gehäuseinnere 11 umfasst einen Stauraum 15 (Fig. 4; 7), in dem die elektrische oder elektronische Baueinheit 16 angeordnet ist. Das Gehäuse 2 ist mehrteilig ausgebildet und weist ein Gehäuseoberteil 3 und ein Gehäuseunterteil 10 auf. Das Gehäuseoberteil 3 ist vom Gehäuseunterteil 10 beschädigungs- und/oder zerstörungsfrei abnehmbar. Das Gehäuseunterteil 10 umfasst eine Gehäuseunterseite 4 und mehrere Seitenwände 5; 6; 7; 8, insbesondere eine Stirnseite 5, eine Rückseite 6 und zwei seitliche Längsseiten 7; 8.

Das Gehäuseunterteil 10, vorzugsweise die Gehäuseunterseite 4, weist nicht gezeigte Kühllufteinlässe auf, durch die Kühlluft 22 zur Kühlung der elektrischen oder elektronischen Baueinheit 16 in das Gehäuseinnere 11 (siehe Fig. 4; 7), insbesondere in den Stauraum 15, einströmen kann. Hierfür weist das Gehäuse 2 oder das elektrische Gerät 1 eine ebenfalls nicht gezeigte Belüftungseinrichtung, zum Beispiel einen Ventilator oder ein Gebläse, auf, durch die die Kühlluft 22 aktiv in das Gehäuseinnere 11 eingeblasen werden kann.

Im Gehäuseoberteil 3 sind mehrere Kühlluftauslässe 18a; 18b; 18c; 18d angeordnet. Jeder Kühlluftauslass 18a; 18b; 18c; 18d ist durch eine Vielzahl an in einer Längserstreckung des Gehäuseoberteils 3 aneinander gereihten und/oder in einer Linie angeordneten Öffnungen, insbesondere Bohrungen, gebildet. Die durch das Gehäuseunterteil 10 in das Gehäuseinnere 11 einströmende Kühlluft 22 kann durch die Kühlluftauslässe 18a; 18b; 18c; 18d aus diesem wieder entweichen. Dadurch kann eine Zirkulation und/oder Zwangskühlung des elektrischen Geräts 1 erreicht werden.

Figur 2 zeigt das elektrische oder elektronische Gerät 1 mit dem Gehäuse 2 aus Fig. 1, wobei das Gehäuseoberteil 3 vom Gehäuseunterteil 10 abgenommen ist. Dadurch ist der Blick auf mehrere miteinander verbundene Zwischendeckenabschnitte 9a; 9b; 9c; 9d; 9e (siehe auch Fig. 3) freigegeben, die eine im Gehäuseinneren 11 und unterhalb des Gehäuseoberteils 3 angeordnete Zwischenebene 24 bilden. Die Zwischenebene 24 kann als ein separates Bauteil in das Gehäuseunterteil 10 eingesetzt sein. Möglich ist aber auch, dass das Gehäuseoberteil 3 die Zwischenebene 24 umfasst und diese mit dem Gehäuseoberteil 3 fest verbunden ist. Die Zwischenebene 24 verläuft parallel zu einer zum Gehäuseinneren 11 gerichteten Innenseite 28 und/oder zu einer der Innenseite 28 gegenüberliegenden Außenseite 29 des Gehäuseoberteils 3, wenn dieses auf dem Gehäuseunterteil 10 aufgesetzt ist.

Die Zwischenebene 24 umfasst mehrere Zwischendeckenstege 12a; 12b; 12d; 12e; 13a; 13b; 13c; 13e (siehe auch Fig. 3), die nach oben, insbesondere in Richtung des Gehäuseoberteils 3, abstehen und/oder vorspringen. Die Zwischendeckenstege 12a; 12b; 12d; 12e; 13a; 13b; 13c; 13e verlaufen durchgehend in Längserstreckung des Gehäuses 2 und sind parallel zur Innen- und/oder Außenseite 28; 29 des Gehäuseoberteils 3 ausgebildet und/oder angeordnet. Die Zwischenebene 24 ist labyrinthartig ausgebildet und/oder bildet ein Labyrinthsystem.

Die Zwischenebene 24 weist Kühlluftdurchlässe 17a; 17b; 17c; 17d; 17e auf, durch die die Kühlluft 22 vom Stauraum 15 durch die Zwischenebene 24 hindurch zur den Kühlluftauslässen 8a; 18b; 18c; 18d im Gehäuseoberteil 3 strömen kann. Insbesondere weist ein, einige oder jeder Zwischendeckensteg 12a; 12b; 12d; 12e; 13a; 13b; 13c; 13e einen Kühlluftdurchlass 17a; 17b; 17c; 17d; 17e auf. Jeder Kühlluftdurchlass 17a; 17b; 17c; 17d; 17e ist durch eine Vielzahl an aneinander gereihten und/oder in einer Linie angeordneten Öffnungen gebildet, die entlang des jeweiligen Zwischendeckenstegs 12a; 12b; 12d; 12e; 13a; 13b; 13c; 13e angeordnet sind.

Figur 3 zeigt einen Schnitt durch das Gehäuseoberteil 3 und durch die miteinander verbundenen Zwischendeckenabschnitte 9a; 9b; 9c; 9d; 9e aus Fig. 1 und 2, wobei die Schnittlinie lotrecht und/oder senkrecht und insbesondere parallel zur Stirnseite 5 verläuft. Die Zwischendeckenabschnitte 9a; 9b; 9c; 9d; 9e sind unterhalb des Gehäuseoberteils 3 angeordnet und an der Innenseite 28 des Gehäuseoberteils 3 befestigt.

Jeder Zwischendeckenabschnitt 9a; 9b; 9c; 9d; 9e ist im Querschnitt U-förmig ausgebildet. Ein erster Schenkel des U's ist als ein erster Zwischendeckensteg 12a; 12b; 12d; 12e und ein zweiter Schenkel des U's als ein zweiter Zwischendeckensteg 13a; 13b; 13c; 13e des jeweiligen Zwischendeckenabschnitts 9a; 9b; 9c; 9d; 9e ausgebildet. Die Querverbindung des U's ist durch einen Zwischendeckenboden 14a; 14b; 14c; 14d; 14e des jeweiligen Zwischendeckenabschnitts 9a; 9b; 9c; 9d; 9e gebildet.

Jeder Zwischendeckenabschnitt 9a; 9b; 9c; 9d; 9e ist als eine vom Gehäuseoberteil 3 abgehängte Decke ausgebildet. Dadurch schließt jeder Zwischendeckenabschnitt 9a; 9b; 9c; 9d; 9e einen Zwischenraum 26a; 26b; 26c; 26d; 26e zwischen dem jeweiligen Zwischendeckenboden 14a; 14b; 14c; 14d; 14e und der Innenseite 28 des Gehäuseoberteils 3 ein.

Jeweils zwei zueinander benachbart angeordnete Zwischendeckenabschnitte 9a; 9b; 9c; 9d; 9e sind durch eine Stegverbindung 30 miteinander verbunden. Insbesondere verbindet eine Stegverbindung 30 immer zwei benachbarte Zwischendeckenstege 12a; 13b; 12b; 13c; 12c; 13e; 12d; 13e zweier benachbarter Zwischendeckenabschnitte 9a; 9b; 9c; 9d; 9e.

Die jeweils benachbarten Zwischendeckenstege 12a; 13b; 12b; 13c; 12c; 13d; 12d; 13e bilden zusammen mit der jeweiligen Stegverbindung 30 eine Aufnahme 25, in der die elektrische oder elektronische Baueinheit 16, insbesondere in der Ausbildung als die Leiterkarte (siehe Figur 4; 7) anordbar ist.

Figur 4 zeigt einen Ausschnitt aus der Schnittdarstellung der Fig. 3, in dem der Zwischendeckenabschnitt 9a in einer Vergrößerung dargestellt ist. Insbesondere ist ein Strömungsweg der Kühlluft 22 durch Pfeile gezeigt.

Der Zwischendeckenabschnitt 9a umfasst den ersten Zwischendeckensteg 12a, den zweiten Zwischendeckensteg 13a und den Zwischendeckenboden 14a. Dieser schließt zusammen mit dem Gehäuseoberteil 3 den Zwischenraum 15 ein.

Der Zwischendeckenabschnitt 9a weist den Kühlluftdurchlass 17a auf. Dieser ist im ersten Zwischendeckensteg 12a angeordnet und/oder durch diesen gebildet. Insbesondere ist der Kühlluftdurchlass 17a an einem oberen Ende des ersten Zwischendeckenstegs 12a, vorzugsweise unmittelbar unterhalb des Gehäuseoberteils 3, angeordnet. Dadurch ist der Kühlluftdurchlass 17a beabstandet und nach oben versetzt vom Zwischendeckenboden 14a angeordnet.

Das Gehäuseoberteil 3 weist den Kühlluftauslass 18a auf. Der Kühlluftauslass 18a ist in dem Schnitt seitlich versetzt zum Kühlluftauslass 17a angeordnet. Insbesondere ist eine erste durch den Kühlluftauslass 18a verlaufende Ebene E1 senkrecht zu einer zweiten durch den Kühlluftdurchlass 17a verlaufenden Ebene E2 angeordnet. Somit sind der Kühlluftauslass 19a und der Kühlluftdurchlass 17a deckungsungleich zueinander angeordnet. Weiterhin ist der Kühlluftdurchlass 17a in der Höhe versetzt zum Kühlluftauslass 18a angeordnet. Die seitlich und in der Höhe versetzte Anordnung des Kühlluftauslasses 18a zum Kühlluftdurchlass 17a unterstützt die labyrinthartige Anordnung und Ausbildung der Zwischenebene 25 bzw. der miteinander über die Stegverbindungen 30 verbundenen Zwischendeckenabschnitte 9a; 9b; 9c; 9d; 9e.

Das Gehäuseinnere 11 umfasst den Stauraum 15, in dem die elektrische oder elektronische Baueinheit 16 in der Ausbildung als die Leiterkartesenkrecht zur Innen- und/oder Außenseite 28; 29 des Gehäuseoberteils 3 angeordnet ist. Zur sicheren Halterung ist die Leiterkarte in die Aufnahme 25, die durch den ersten Zwischendeckensteg 12a des Zwischendeckenabschnitts 9a und den benachbarten zweiten Zwischendeckensteg 13b des Zwischendeckenabschnitts 9b und durch die Stegverbindung 30 gebildet ist, eingeschoben. In der Aufnahme 25 ist die Leiterkarte form- und/oder reibschlüssig zwischen zwei Bestückungsflächen der beiden Zwischendeckenstege 12a; 13b gehalten.

Die durch die Gehäuseunterseite 4 in den Stauraum 15 einströmende Kühlluft 22 entlang der senkrecht zur Innen- und/oder Außenseite 28; 29 des Gehäuseoberteils 3 angeordneten Leiterkarte 16 nach oben. Die Kühlluft 22 strömt durch den Kühlluftdurchlass 17a in den Zwischenraum 26a. Vom Zwischenraum 26a aus kann die Kühlluft 22 durch den Kühlluftauslass 18a nach außen, insbesondere in eine Umgebung des Gehäuses 2, entweichen. Wie anhand der die Kühlluft 22 darstellenden Pfeile deutlich ersichtlich, wird die Kühlluft 22 auf ihrem Strömungsweg vom Stauraum 15 über den Kühlluftdurchlass 17a in den Zwischenraum 26a um mindestens 90 Grad, vorzugsweise um mindestens 140 Grad und maximal um 180 Grad umgelenkt. Auf ihrem Strömungsweg vom Zwischenraum 26a über den Kühlluftauslass 18a nach außen wird die Kühlluft 22 in ihrer Strömungsrichtung um mindestens 60 Grad, vorzugsweise um mindestens 90 Grad und maximal um 180 Grad umgelenkt.

Insbesondere wird durch die labyrinthartige Anordnung und Ausbildung der Zwischenebene 24 (siehe Fig. 2) erreicht, dass die Kühlluft 22 nicht direkt und auf geradem Wege durch das Gehäuseinnere 11 strömt, sondern mehrmals, insbesondere zweimal wie eben beschrieben, auf ihrem Weg durch das Gehäuseinnere 11 in ihrer Strömungsrichtung umgeleitet wird. Gleichzeitig wird durch die labyrinthartige Ausbildung und/oder Anordnung der Zwischenebene 24 erreicht, dass das in dem Zwischendeckenabschnitt 9a aufgefangene und gesammelte Tropfwasser 19 nicht in den Stauraum 15 gelangen kann.

Die Figur 7 zeigt die Darstellung der Figur 4, insbesondere eine Detaildarstellung des Zwischendeckenabschnitts 9a und des Kühlluftauslasses 18a. Es ist zusätzlich zum Strömungsweg der Kühlluft 22 ein Fließweg von Tropfwasser 19, insbesondere Kondenswasser, durch Tropfensymbole dargestellt. Der Fließweg ist beispielhaft für alle weiteren Zwischendeckenabschnitte 9b; 9c; 9d; 9e und Kühlluftauslässe 18b; 18c; 18d; 18e gezeigt.

Das Gehäuseoberteil 3 weist eine erste und eine zweite Rippe 20; 21 auf, die sich seitlich an den Kühlluftauslass 18a anschließen und vom Gehäuseoberteil 3 rechtwinklig in den Zwischenraum 26a abstehen. Das Tropfwasser 19 gelangt durch den Kühlluftauslass 18a in den Zwischenraum 26a, indem es entlang der ersten und zweiten Rippe 20; 21 fließt.

Die erste und zweite Rippe 20; 21 sind als Abtropfrippen für das eindringende Tropfwasser 19 ausgebildet. Insbesondere wird das Tropfwasser 19 entlang der Abtropfrippen 20; 21 in den Zwischenraum 26a geleitet, indem es direkt auf den Zwischendeckenboden 14a abtropft. Durch die Abtropfrippen 20; 21 wird in vorteilhafter Weise verhindert, dass das Tropfwasser 19 entlang der Innenseite 28 des Gehäuseoberteils 3 in Richtung mindestens einer der Seitenwände 5; 6; 7; 8 wandert und von dort aus in den Stauraum 15 gelangen kann.
Im Zwischendeckenabschnitt 9a wird das Tropfwasser 19 auf dem Zwischendeckenboden 14a aufgefangen. Durch seine U-förmige Ausgestaltung bildet der Zwischendeckenabschnitt 9a einen Sammelkanal für das eindringende Tropfwasser 19. Dadurch, dass der Kühlluftdurchlass 17a im ersten Zwischendeckensteg 12a nach oben versetzt und vom Zwischendeckenboden 14a beabstandet angeordnet ist, bildet ein darunter liegender Bereich des Zwischendeckenstegs 12a eine Wasserbarriere und/oder ein Wehr gegen das aufgefangene und gesammelte Tropfwasser. Insbesondere kann dieses nicht durch den Kühlluftdurchlass 17a in den Stauraum 15 eindringen. Es besteht also kein direkter Fließweg vom Zwischenraum 26a in den Stauraum 15 für das Tropfwasser.

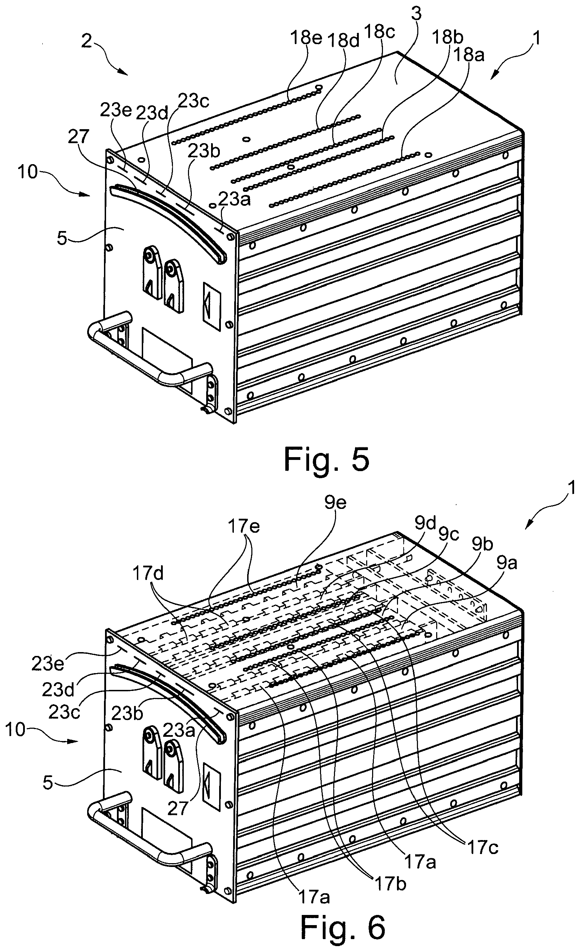

Figur 5 zeigt das elektrische Gerät 1 aus Fig. 1 mit einem abgewandelten Gehäuse 2. Die Stirnseite 5 des Gehäuses 2 weist mehrere Abflussöffnungen 23a; 23b; 23c; 23d; 23e auf, durch die das in den einzelnen Zwischendeckenabschnitten 9a; 9b; 9c; 9d; 9e (siehe beispielhaft Fig. 7) aufgefangene Tropfwasser 19 nach außen, durch die Stirnseite 5 hindurch, abgeleitet werden kann.

Figur 6 zeigt das elektrische Gerät 1 mit dem abgewandelten Gehäuse 2 aus Figur 5, wobei das Gehäuseoberteil 3 vom Gehäuseunterteil 10 abgenommen ist. Jeder Zwischendeckenabschnitt 9a; 9b; 9c; 9d; 9e mündet in der ihm zugeordneten Abflussöffnung 23a; 23b; 23c; 23d; 23e, damit das Tropfwasser 19 aus diesen nach außen abfließen kann.

Das Gehäuse 2 weist eine Ableiteinrichtung 27 auf, die zur Ableitung des aus den Abflussöffnungen 23a; 23b; 23c; 23d ausgeleiteten Tropfwassers 19 ausgebildet ist. Die Ableiteinrichtung 27 ist an der Stirnseite 5 des Gehäuses 2 angeordnet und konstruktiv als eine konvex gekrümmte Ableitrinne umgesetzt. Somit kann das Tropfwasser 19 gezielt um Buchsen und/oder Stecker herumgeleitet werden, die auf der Stirnseite 5 angeordnet sind.

In Figur 8 ist das elektrische oder elektronische Gerät 1 mit dem abgewandelten Gehäuse 2 aus Fig. 5 gezeigt, wobei die erste seitliche Längsseite 7 und ein Teil des Gehäuseoberteils 3 transparent dargestellt ist. Durch die transparente Darstellung ist der Blick auf die senkrecht zur Innen- und/oder Außenseite 28; 29 des Gehäuseoberteils 3 angeordnete Leiterkarte 16 freigegeben. Das Gehäuseoberteil 3 weist die Kühlluftauslässe 18a; 18b; 18c; 18d auf. Durch die Transparenz ist der Blick frei auf die erste und zweite Sicke 20; 21, insbesondere Abtropfsicke, an der das durch den Kühlluftauslass 18a eindringende Tropfwasser 19 auf den Zwischendeckenboden 14a gezielt abtropft. Der Zwischendeckenabschnitt 9a mit dem Zwischendeckenboden 14a und dem Zwischendeckensteg 12a ist ebenfall sichtbar. Im Zwischendeckensteg 12a ist der nach oben versetzte und vom Zwischendeckenboden 14a beabstandet angeordnete Kühlluftdurchlass 17a angeordnet. Der darunter liegende Bereich des Zwischendeckenstegs 12a ist als das Wehr oder als die Barriere gegen das im Zwischendeckenabschnitt 9a gesammelte Tropfwasser 19 ausgebildet.

Zusammenfassend wird gemäß Fig. 1 und 5 ein zwangsbelüftetes, offenes und für Kühlluft 22 durchgängiges Gerät 1, insbesondere Gehäuse 2, bereitgestellt, sodass die elektrische oder elektronische Baueinheit während des Betriebs gekühlt und eine Überhitzung des elektrischen Geräts 1 vermieden werden kann. Gleichzeitig kann durch die labyrinthartige Ausbildung der Zwischenebene 24 gemäß Fig. 2 und/oder durch die in den Figuren 3; 4; 6; 7; 8 gezeigte spezifische Ausbildung und Anordnung der Zwischendeckenabschnitte 9a; 9b; 9c; 9d; 9e mit den seitlich und in der Höhe versetzten Kühlluftaus- und Durchlässen 18a; 17a; 18b; 17b; 18c; 17c; 18d; 17d; 18e; 17e gewährleistet werden, dass trotz des offenen zwangsbelüfteten Gerätes 1 kein Tropfwasser 19 in den Stauraum 15 des Gehäuses 2 gelingen kann.

### Bezugszeichenliste

- 1: elektrisches oder elektronisches Gerät
- 2: Gehäuse
- 3: Gehäuseoberteil
- 4: Gehäuseunterseite
- 5: Stirnseite
- 6: Rückseite
- 7: erste seitliche Längsseite
- 8: zweite seitliche Längsseite
- 9a-e: Zwischendeckenabschnitte
- 10: Gehäuseunterteil
- 11: Gehäuseinneres
- 12a-e: Zwischendeckensteg
- 13a-e: Zwischendeckensteg
- 14a-e: Zwischendeckenboden
- 15a-e: Stauraum
- 16: elektrische oder elektronische Baueinheit
- 17a-e: Kühlluftdurchlass
- 18a-e: Kühlluftauslass
- 19: Tropfwasser
- 20: erste Rippe
- 21: zweite Rippe
- 22: Kühlluft
- 23a-e: Abflussöffnungen
- 24: Zwischenebene
- 25: Aufnahme für Leiterkarte
- 26a-e: Zwischenraum
- 27: Ableiteinrichtung
- 28: Innenseite des Gehäuseoberteils
- 29: Außenseite des Gehäuseoberteils
- 30: Stegverbindung

## Patentansprüche

1. Gehäuse (2) für mindestens eine elektrische oder elektronische Baueinheit (16), wobei das Gehäuse (2) ein Gehäuseinneres (11) mit einem Stauraum (15) umschließt, wobei die elektrische oder elektronische Baueinheit (16) in dem Stauraum (15) anordbar ist,
wobei das Gehäuse (2) ein Gehäuseoberteil (3) umfasst, das das Gehäuseinnere (11) begrenzt,
wobei das Gehäuse (2) mindestens einen Zwischendeckenabschnitt (9a; 9b; 9c; 9d; 9e) umfasst, der im Gehäuseinneren (11) unterhalb des Gehäuseoberteils (3) angeordnet ist und zusammen mit dem Gehäuseoberteil (3) mindestens einen Zwischenraum (26a; 26b; 26c; 26d; 26e) einschließt,
wobei der Zwischendeckenabschnitt (9a; 9b; 9c; 9d; 9e) mindestens einen Kühlluftdurchlass (17a; 17b; 17c; 17d; 17e)aufweist, durch den Kühlluft (22) vom Stauraum (15) in den Zwischenraum (26a; 26b; 26c; 26d; 26e) strömen kann,
wobei das Gehäuseoberteil (3) mindestens einen Kühlluftauslass (18a; 18b; 18c; 18d; 18e) aufweist, durch den die Kühlluft (22) aus dem Zwischenraum (26a; 26b; 26c; 26d; 26e) nach außen entweichen kann,
und wobei
der Zwischendeckenabschnitt (9a; 9b; 9c; 9d; 9e) eine Auffangeinrichtung für Tropfwasser (19) bildet, das durch den Kühlluftauslass (18a; 18b; 18c; 18d; 18e) in den Zwischenraum (26a; 26b; 26c; 26d; 26e) eindringt,
**dadurch gekennzeichnet, dass**
das Gehäuse (2) mehrere Zwischendeckenabschnitte (9a; 9b; 9c; 9d; 9e) aufweist, wobei die Zwischendeckenabschnitte (9a; 9b; 9c; 9d; 9e) durch Stegverbindungen (30) miteinander verbunden sind,
wobei jeweils eine der Stegverbindungen (30) zwischen zwei benachbarten Zwischendeckenstegen (12a; 13b; 12b; 13c; 12c; 13e; 12d; 13e) zweier benachbarter Zwischendeckenabschnitte (9a; 9b; 9c; 9d; 9e) angeordnet ist, wobei die zwei benachbarten Zwischendeckenstege (12a; 13b; 12b; 13c; 12c; 13e; 12d; 13e) zusammen mit der Stegverbindung (30) eine Aufnahme (25) bilden, in der die elektrische oder elektronische Baueinheit (16) anordnenbar ist.

2. Gehäuse (2) nach Anspruch 1, **dadurch gekennzeichnet, dass** der Zwischendeckenabschnitt (9a; 9b; 9c; 9d; 9e) in einem senkrechten und/oder lotrechten Querschnitt U-förmig ausgebildet ist, wobei ein erster Schenkel des Us als ein erster Zwischendeckensteg (12a; 12b; 12c; 12d; 12e), ein zweiter Schenkel des Us als ein zweiter Zwischendeckensteg (13a; 13b; 13c; 13d; 13e) und eine Querverbindung des Us als ein Zwischendeckenboden (14a; 14b; 14c; 14d; 14e) ausgebildet ist.

3. Gehäuse (2) nach Anspruch 2, **dadurch gekennzeichnet, dass** der Kühlluftdurchlass (17a; 17b; 17c; 17d; 17e) im ersten Zwischendeckensteg (12a; 12b; 12c; 12d; 12e) und/oder im zweiten Zwischendeckensteg (13a; 13b; 13c; 13d; 13e) angeordnet ist und/oder durch den ersten Zwischendeckensteg (12a; 12b; 12c; 12d; 12e) und/oder zweiten Zwischendeckensteg (13a; 13b; 13c; 13d; 13e) gebildet ist.

4. Gehäuse (2) nach Anspruch 2 oder 3, **dadurch gekennzeichnet, dass** der Kühlluftdurchlass (17a; 17b; 17c; 17d; 17e) vom Zwischendeckenboden (14a; 14b; 14c; 14d; 14e) beabstandet und nach oben versetzt angeordnet ist, sodass das auf dem Zwischendeckenboden (14a; 14b; 14c; 14d; 14e) aufgefangene Tropfwasser (19) an einem Eindringen in den Stauraum (15) des Gehäuses (2) durch den Kühlluftdurchlass (17a; 17b; 17c; 17d; 17e) gehindert wird.

5. Gehäuse (2) nach einem der vorhergehenden Ansprüche, **dadurch gekennzeichnet, dass** der Kühlluftdurchlass (17a; 17b; 17c; 17d; 17e) in einem senkrechten und/oder lotrechten Querschnitt seitlich versetzt zum Kühlluftauslass (18a; 18b; 18c; 18d; 18e) angeordnet ist.

6. Gehäuse (2) nach einem der vorhergehenden Ansprüche, **dadurch gekennzeichnet, dass** die Kühlluft (22) beim Strömen vom Stauraum (15) in den Zwischenraum (26a; 26b; 26c; 26d; 26e) und vom Zwischenraum (26a; 26b; 26c; 26d; 26e) nach außen mindestens zweimal in ihrer Strömungsrichtung um mindestens 60 Grad, vorzugsweise um mindestens 90 Grad, insbesondere um mindestens 140 Grad und/oder maximal um 180 Grad umgelenkt wird.

7. Gehäuse (2) nach einem der vorhergehenden Ansprüche, **dadurch gekennzeichnet, dass** das Gehäuseoberteil (3) eine erste Rippe (20) und zweite Rippe (21) aufweist, wobei sich die erste und zweite Rippe (20; 21) seitlich an den Kühlluftauslass (18a; 18b; 18c; 18d; 18e) anschließen und von dem Gehäuseoberteil (3) winklig in den Zwischenraum (26a; 26b; 26c; 26d; 26e) abstehen.

8. Gehäuse (2) nach Anspruch 7, **dadurch gekennzeichnet, dass** die erste und zweite Rippe (20; 21) als Abtropfrippen für das durch die Kühlluftauslass (18a; 18b; 18c; 18d; 18e) in den Zwischenraum (26a; 26b; 26c; 26d; 26e) eindringende Tropfwasser (19) ausgebildet sind.

9. Gehäuse (2) nach einem der vorhergehenden Ansprüche, **dadurch gekennzeichnet, dass** das Gehäuse (2) mehrere Seitenwände (5; 6; 7; 8) aufweist, wobei mindestens eine der Seitenwände (5; 6; 7; 8) mindestens eine Abflussöffnung (23a; 23b; 23c; 23d; 23e) aufweist, in die der Zwischendeckenabschnitt (9a; 9b; 9c; 9d; 9e) als die Auffangeinrichtung und als eine Ablaufeinrichtung mündet, sodass das dort aufgefangene Tropfwasser (19) nach außen geleitet werden kann.

10. Gehäuse (2) nach Anspruch 9, **dadurch gekennzeichnet, dass** das Gehäuse (2) mindestens eine Ableiteinrichtung (27) zur gezielten Ableitung des aus der Abflussöffnung (23a; 23b; 23c; 23d; 23e) ausgeleiteten Tropfwassers (19) aufweist.

11. Gehäuse (2) nach einem der vorhergehenden Ansprüche, **dadurch gekennzeichnet, dass** die mehreren miteinander verbundenen Zwischendeckenabschnitte (9a; 9b; 9c; 9d; 9e) eine Zwischenebene (24) bilden, wobei die Zwischenebene (24) labyrinthartig ausgebildet ist und/oder ein Labyrinthsystem bildet.

12. Elektrisches oder elektronisches Gerät (1) mit dem Gehäuse (2) nach einem der vorhergehenden Ansprüche, **dadurch gekennzeichnet, dass** das elektrische oder elektronische Gerät (1) die elektrische oder elektronische Baueinheit (30) umfasst, die im Stauraum (15) in der zwischen den über die Stegverbindung (30) verbundenen Zwischendeckenstege (12a; 13b; 12b; 13c; 12c; 13e; 12d; 13e) gebildeten Aufnahme (25) angeordnet ist, wobei die Kühlluft (22) entlang der elektrischen oder elektronischen Baueinheit (16) und senkrecht zu einer Innen- und/oder Außenseite (28; 29) des Gehäuseoberteils (3) nach oben zum Kühlluftdurchlass (17a; 17b; 17c; 17d; 17e) geleitet wird.

13. Elektrisches oder elektronisches Gerät (1) nach Anspruch 12, **dadurch gekennzeichnet, dass** das elektrische oder elektronische Gerät (1) als ein Rechner, insbesondere als ein Avionik-Rechner, ausgebildet ist.

## Claims

1. Housing (2) for at least one electric or electronic unit (16),
the housing (2) surrounding a housing interior (11) comprising a storage space (15), the electric or electronic unit (16) being arrangeable in the storage space (15),
the housing (2) comprising a housing upper part (3), which delimits the housing interior (11),
the housing (2) comprising at least one intermediate ceiling portion (9a; 9b; 9c; 9d; 9e), which is arranged in the housing interior (11) below the housing upper part (3) and, together with the housing upper part (3), encloses at least one intermediate space (26a; 26b; 26c; 26d; 26e),
the intermediate ceiling portion (9a; 9b; 9c; 9d; 9e) having at least one cooling air passage (17a; 17b; 17c; 17d; 17e), through which cooling air (22) can flow from the storage space (15) into the intermediate space (26a; 26b; 26c; 26d; 26e),
the housing upper part (3) having at least one cooling air outlet (18a; 18b; 18c; 18d; 18e), through which the cooling air (22) can escape outwardly from the intermediate space (26a; 26b; 26c; 26d; 26e),
and
the intermediate ceiling portion (9a; 9b; 9c; 9d; 9e) forming a catching arrangement for dripping water (19), which infiltrates the intermediate space (26a; 26b; 26c; 26d; 26e) through the cooling air outlet (18a; 18b; 18c; 18d; 18e),
**characterized in that**
the housing (2) has a plurality of intermediate ceiling portions (9a; 9b; 9c; 9d; 9e), the intermediate ceiling portions (9a; 9b; 9c; 9d; 9e) being interconnected by web connections (30),
each web connection (30) being arranged between two adjacent intermediate ceiling webs (12a; 13b; 12b; 13c; 12c; 13e; 12d; 13e) of two adjacent intermediate ceiling portions (9a; 9b; 9c; 9d; 9e), the two adjacent intermediate ceiling webs (12a; 13b; 12b; 13c; 12c; 13e; 12d; 13e), together with the web connection (30), forming a receptacle (25), in which the electric or electronic unit (16) can be arranged.

2. Housing (2) according to Claim 1, **characterized in that** the intermediate ceiling portion (9a; 9b; 9c; 9d; 9e) is U-shaped in a perpendicular and/or vertical cross section, a first branch of the U being configured as a first intermediate ceiling web (12a; 12b; 12c; 12d; 12e), a second branch of the U being configured as a second intermediate ceiling web (13a; 13b; 13c; 13d; 13e), and a transverse connection of the U being configured as an intermediate ceiling base (14a; 14b; 14c; 14d; 14e).

3. Housing (2) according to Claim 2, **characterized in that** the cooling air passage (17a; 17b; 17c; 17d; 17e) is arranged in the first intermediate ceiling web (12a; 12b; 12c; 12d; 12e) and/or in the second intermediate ceiling web (13a; 13b; 13c; 13d; 13e), and/or is formed by the first intermediate ceiling web (12a; 12b; 12c; 12d; 12e) and/or second intermediate ceiling web (13a; 13b; 13c; 13d; 13e).

4. Housing (2) according to Claim 2 or 3, **characterized in that** the cooling air passage (17a; 17b; 17c; 17d; 17e) is distanced from the intermediate ceiling base (14a; 14b; 14c; 14d; 14e) and is offset upwardly, such that the dripping water (19) caught on the intermediate ceiling base (14a; 14b; 14c; 14d; 14e) is prevented from infiltrating the storage space (15) of the housing (2) through the cooling air passage (17a; 17b; 17c; 17d; 17e).

5. Housing (2) according to one of the preceding claims, **characterized in that** the cooling air passage (17a; 17b; 17c; 17d; 17e) is laterally offset from the cooling air outlet (18a; 18b; 18c; 18d; 18e) in a perpendicular and/or vertical cross section.

6. Housing (2) according to one of the preceding claims, **characterized in that** the cooling air (22), when flowing from the storage space (15) into the intermediate space (26a; 26b; 26c; 26d; 26e) and when flowing outwardly from the intermediate space (26a; 26b; 26c; 26d; 26e), is deflected at least twice in its flow direction by at least 60 degrees, preferably by at least 90 degrees, in particular by at least 140 degrees and/or at most by 180 degrees.

7. Housing (2) according to one of the preceding claims, **characterized in that** the housing upper part (3) has a first rib (20) and second rib (21), the first and second rib (20; 21) adjoining the cooling air outlet (18a; 18b; 18c; 18d; 18e) laterally and protruding at an angle from the housing upper part (3) into the intermediate space (26a; 26b; 26c; 26d; 26e).

8. Housing (2) according to Claim 7, **characterized in that** the first and second rib (20; 21) are configured as draining ribs for the dripping water (19) infiltrating the intermediate space (26a; 26b; 26c; 26d; 26e) through the cooling air outlet (18a; 18b; 18c; 18d; 18e).

9. Housing (2) according to one of the preceding claims, **characterized in that** the housing (2) has a plurality of side walls (5; 6; 7; 8), at least one of the side walls (5; 6; 7; 8) having at least one drainage opening (23a; 23b; 23c; 23d; 23e), into which the intermediate ceiling portion (9a; 9b; 9c; 9d; 9e), as the catching arrangement and as a run-off arrangement, discharges, such that the dripping water (19) caught there can be guided outwardly.

10. Housing (2) according to Claim 9, **characterized in that** the housing (2) has at least one diverting arrangement (27) for selectively diverting the dripping water (19) discharged from the drainage opening (23a; 23b; 23c; 23d; 23e).

11. Housing (2) according to one of the preceding claims, **characterized in that** the plurality of interconnected intermediate ceiling portions (9a; 9b; 9c; 9d; 9e) form an intermediate plane (24), the intermediate plane (24) being labyrinth-like and/or forming a labyrinth system.

12. Electric or electronic device (1) comprising the housing (2) according to one of the preceding claims, **characterized in that** the electric or electronic device (1) comprises the electric or electronic unit (30), which is arranged in the storage space (15) in the receptacle (25) formed between the intermediate ceiling webs (12a; 13b; 12b; 13c; 12c; 13e; 12d; 13e) connected via the web connection (30), the cooling air (22) being guided upwardly to the cooling air passage (17a;, 17b; 17c; 17d; 17e), along the electric or electronic unit (16) and perpendicularly to an inner face and/or outer face (28; 29) of the housing upper part (3).

13. Electric or electronic device (1) according to Claim 12, **characterized in that** the electric or electronic device (1) is configured as a computer, in particular as an avionics computer.

## Revendications

1. Boîtier (2) pour au moins un composant électrique ou électronique (16), dans lequel le boîtier (2) renferme un intérieur de boîtier (11) avec un espace de mise en place (15), dans lequel le composant électrique ou électronique (16) peut être disposé dans l'espace de mise en place (15),
dans lequel le boîtier (2) comprend une partie supérieure de boîtier (3) définissant l'intérieur de boîtier (11), dans lequel le boîtier (2) comprend au moins une partie formant plafond intermédiaire (9a ; 9b ; 9c ; 9d ; 9e) disposée dans l'intérieur de boîtier (11) sous la partie supérieure de boîtier (3) et incluant conjointement avec la partie supérieure de boîtier (3) au moins un espace intermédiaire (26a ; 26b ; 26c ; 26d ; 26e),
dans lequel la partie formant plafond intermédiaire (9a ; 9b ; 9c ; 9d ; 9e) comporte au moins un passage d'air de refroidissement (17a ; 17b ; 17c ; 17d ; 17e), à travers lequel de l'air de refroidissement (22) peut circuler de l'espace de mise en place (15) vers l'espace intermédiaire (26a ; 26b ; 26c ; 26d ; 26e),
dans lequel la partie supérieure de boîtier (3) comporte au moins une sortie d'air de refroidissement (18a ; 18b ; 18c ; 18d ; 18e) à travers laquelle l'air de refroidissement (22) peut s'échapper vers l'extérieur de l'espace intermédiaire (26a ; 26b ; 26c ; 26d ; 26e),
et dans lequel la partie formant plafond intermédiaire (9a ; 9b ; 9c ; 9d ; 9e) constitue un moyen collecteur d'égouttement (19) qui pénètre à travers la sortie d'air de refroidissement (18a ; 18b ; 18c ; 18d ; 18e) dans l'espace intermédiaire (26a ; 26b ; 26c ; 26d ; 26e), **caractérisé en ce que** le boîtier (2) comprend une pluralité de parties formant plafonds intermédiaires (9a ; 9b ; 9c ; 9d ; 9e), dans lequel les parties formant plafonds intermédiaires (9a ; 9b ; 9c ; 9d ; 9e) sont reliées entre elles par des entretoises (30),
dans lequel l'une des entretoises (30) est respectivement disposée entre deux traverses de plafond intermédiaires adjacentes (12a ; 13b ; 12b ; 13c ; 12c ; 13e ; 12d ; 13e) de deux parties formant plafonds intermédiaires adjacentes (9a ; 9b ; 9c ; 9d ; 9e), dans lequel les deux traverses de plafond intermédiaires adjacentes (12a ; 13b ; 12b ; 13c ; 12c ; 13e ; 12d ; 13e) forment conjointement avec l'entretoise (30) un réceptacle (25) dans lequel le composant électrique ou électronique (16) peut être disposé.

2. Boîtier (2) selon la revendication 1, **caractérisé en ce que** la partie formant plafond intermédiaire (9a ; 9b ; 9c ; 9d ; 9e) présente une forme de U en section transversale verticale et/ou verticale, dans lequel une première branche du U présente la forme d'une première traverse de plafond intermédiaire (12a ; 12b ; 12c ; 12d ; 12e), une deuxième branche du U présente la forme d'une deuxième traverse de plafond intermédiaire (13a ; 13b ; 13c ; 13d ; 13e) et une liaison transversale du U présente la forme d'un fond de plafond intermédiaire (14a ; 14b ; 14c ; 14d ; 14e).

3. Boîtier (2) selon la revendication 2, **caractérisé en ce que** le passage d'air de refroidissement (17a ; 17b ; 17c ; 17d ; 17e) est disposé dans la première traverse de plafond intermédiaire (12a ; 12b ; 12c ; 12d ; 12e) et/ou dans la deuxième traverse de plafond intermédiaire (13a ; 13b ; 13c ; 13d ; 13e) et/ou est formé par la première traverse de plafond intermédiaire (12a ; 12b ; 12c ; 12d ; 12e) et/ou par la deuxième traverse de plafond intermédiaire (13a ; 13b ; 13c ; 13d ; 13e).

4. Boîtier (2) selon la revendication 2 ou 3, **caractérisé en ce que** le passage d'air de refroidissement (17a ; 17b ; 17c ; 17d ; 17e) est espacé du fond de plafond intermédiaire (14a ; 14b ; 14c ; 14d ; 14e) et est disposé décalé vers le haut, de manière à ce que l'eau d'égouttement (19) recueillie sur le fond de plafond intermédiaire (14a ; 14b ; 14c ; 14d ; 14e) soit empêchée de pénétrer dans l'espace de mise en place (15) du boîtier (2) à travers le passage d'air de refroidissement (17a ; 17b ; 17c ; 17d ; 17e).

5. Boîtier (2) selon l'une des revendications précédentes, **caractérisé en ce que** le passage d'air de refroidissement (17a ; 17b ; 17c ; 17d ; 17e) est disposé dans une section transversale verticale et/ou verticale décalée latéralement par rapport à la sortie d'air de refroidissement (18a ; 18b ; 18c ; 18d ; 18e).

6. Boîtier (2) selon l'une des revendications précédentes, **caractérisé en ce que** la direction d'écoulement de l'air de refroidissement (22) est déviée au moins deux fois d'au moins 60 degrés, de préférence d'au moins 90 degrés, en particulier d'au moins 140 degrés et/ou au plus de 180 degrés, lorsqu'il s'écoule depuis l'espace de mise en place (15) vers l'espace intermédiaire (26a ; 26b ; 26c ; 26d ; 26e) et depuis l'espace intermédiaire (26a ; 26b ; 26c ; 26d) vers l'extérieur.

7. Boîtier (2) selon l'une des revendications précédentes, **caractérisé en ce que** la partie supérieure de boîtier (3) présente une première nervure (20) et une deuxième nervure (21), dans lequel les première et deuxième nervures (20 ; 21) se raccordent latéralement à la sortie d'air de refroidissement (18a ; 18b ; 18c ; 18d ; 18e) et font saillie sous un certain angule depuis la partie supérieure de boîtier (3) dans l'espace (26a ; 26b ; 26c ; 26d ; 26e).

8. Boîtier (2) selon la revendication 7, **caractérisé en ce que** les première et deuxième nervures (20 ; 21) sont réalisées sous la forme de nervures d'égouttement pour l'eau d'égouttement (19) pénétrant par la sortie d'air de refroidissement (18a ; 18b ; 18c ; 18d ; 18e) dans l'espace intermédiaire (26a ; 26b ; 26c ; 26d ; 26e).

9. Boîtier (2) selon l'une des revendications précédentes, **caractérisé en ce que** le boîtier (2) présente une pluralité de parois latérales (5 ; 6 ; 7 ; 8), dans lequel au moins l'une des parois latérales (5 ; 6 ; 7 ; 8) présente au moins une ouverture d'évacuation (23a ; 23b ; 23c ; 23d ; 23e) dans laquelle la partie formant plafond intermédiaire (9a ; 9b ; 9c ; 9d ; 9e) s'ouvre en tant que dispositif collecteur et en tant que dispositif d'évacuation, de manière à ce que l'eau d'égouttement (19) qui y est recueillie puisse être dirigée vers l'extérieur.

10. Boîtier (2) selon la revendication 9, **caractérisé en ce que** le boîtier (2) comporte au moins un dispositif d'évacuation (27) pour l'évacuation ciblée de l'eau d'égouttement (19) évacuée par l'ouverture d'évacuation (23a ; 23b ; 23c ; 23d ; 23e).

11. Boîtier (2) selon l'une des revendications précédentes, **caractérisé en ce que** les différentes parties formant plafond intermédiaires interconnectées (9a ; 9b ; 9c ; 9d ; 9e) forment un plan intermédiaire (24), dans lequel le plan intermédiaire (24) est réalisé sous la forme d'un labyrinthe et/ou sous la forme d'un système de labyrinthe.

12. Appareil électrique ou électronique (1) doté du boîtier (2) selon l'une des revendications précédentes, **caractérisé en ce que** l'appareil électrique ou électronique (1) comprend le composant électrique ou électronique (30) qui est disposé dans l'espace de mise en place (15) dans le réceptacle (25) formé entre les traverses de plafond intermédiaires (12a ; 13b ; 12b ; 13c ; 12c ; 13e ; 12d ; 13e) reliées par l'intermédiaire de l'entretoise (30), dans lequel l'air de refroidissement (22) est dirigé vers le haut le long du composant électrique ou électronique (16) et perpendiculairement à une face intérieure et/ou extérieure (28 ; 29) de la partie supérieure de boîtier (3) vers le passage d'air de refroidissement (17a ; 17b ; 17c ; 17d ; 17e).

13. Appareil électrique ou électronique (1) selon la revendication 12, **caractérisé en ce que** l'appareil électrique ou électronique (1) est réalisé sous la forme d'un ordinateur, en particulier d'un ordinateur d'avionique.
